# EUROPEAN PATENT APPLICATION

(11) **EP 2 530 801 A1**
(43) Date of publication of application: **05.12.2012**
(21) Application number: 11168202.7
(22) Date of filing: 31.05.2011
(51) Int. Cl.: H02H 3/17, H02H 7/06, G01R 31/34

(54) **Ground fault protection**

(71) Applicant: ABB Schweiz AG, 5400 Baden (CH)
(72) Inventor: Callsen, Andreas, 8311 Brütten (CH)
(74) Representative: ABB Patent Attorneys

(57) **Abstract**

The present invention is concerned with a robust ground-fault protection system having a reduced sensitivity to system noise. In a ground-fault protection system for an electrical machine such as a generator, an injection signal with an injection frequency *fᵢ* is applied to the electrical machine in order to generate a periodic bias voltage on a conductor of the electrical machine, and a response signal thereto is evaluated. The injection frequency is adapted, i.e. adjusted or selected depending on a system quantity or system property of the electrical machine that is indicative of system noise interfering with, or superposing, the response signal. Hence, a static, predetermined choice of the injection frequency is abandoned in favour of a flexible approach respective of a most recent value of a system quantity of the electrical machine, which ultimately results in increased stability and reliability of the ground-fault protection system.

## Description

### FIELD OF THE INVENTION

The invention relates to the field of protective relaying, and in particular to earth fault protection in large electrical machines. It departs from a ground-fault protection system for an electrical machine as described in the preamble of claim 7.

### BACKGROUND OF THE INVENTION

A method for detecting ground faults on conductors of an electrical machine such as a large generator is disclosed in US 5739693. Ground faults occur because of mechanical damage to the electrical insulation between conductors and iron parts on ground potential. Ground faults result in fault currents from which a fault resistance can be calculated and evaluated to assess the fault. In order to detect a fault in the vicinity of a de-energized star point of a generator, i.e. at or near generator neutral, the conductors of the generator are biased with respect to ground potential by means of a suitable injection signal. Actively injecting a biasing signal results in a so-called "100% Stator Earth Protection" frequently used in Generator Protection systems.

In detail, a periodic rectangular injection signal with a fixed injection frequency equal to one quarter of the nominal network frequency (i.e. 12.5 Hz in 50 Hz grids or 15 Hz in 60 Hz grids) is injected by a dedicated signal generator trough an injection transformer and the grounding resistors into the stator or rotor winding. A synchronized protection relay measures a response signal to this injection. From the response signal, a ground fault in the generator neutral or in the rotor circuit side can be calculated.

A ground fault protection system of this kind is sensitive to disturbances which may lead to a false operation or to non-operation with adverse effects for both the operating utility and the power consumers. In particular, the generator neutral (for the stator ground fault protection system) experiences, and the excitation system (for the rotor ground fault protection system) actually generates parasitic electromagnetic signals, or noise, in certain frequency bands which might disturb the ground fault protection functions.

Likewise, existing ground fault protection systems may be sensitive to over- or under-frequency conditions. In particular, in cases where the generator speed fell below 50 Hz (e.g. to as little as 48.5 Hz, which is not uncommon in weak grids), rotor earth fault functions were found to trip spontaneously. For generators with static excitation the harmonics (caused by the thyristors of the excitation system) at a multiple of the generator frequency (i.e. 300 Hz when the generator runs at 50 Hz or 291 Hz when the generator runs at 48.5 Hz) are eliminated by digital filters incorporated in the protection function that evaluates the response signal. However, a nominal and static 300 Hz digital filter of the protection algorithm is less efficient for filtering 291 Hz noise. Hence, when the generator speed starts deviating from the nominal grid frequency, some noise leaks into the protection function and eventually causes a false trip.

### DESCRIPTION OF THE INVENTION

It is therefore an objective of the invention to provide a more robust ground-fault protection system with a reduced sensitivity to system noise. This objective is achieved by a method of adapting a ground-fault protection system and a ground-fault protection system according to the independent patent claims. Further preferred embodiments are evident from the dependent patent claims.

According to the invention, in a ground-fault protection system for an electrical machine such as a generator, an injection signal with an injection frequency *fᵢ* is applied to the electrical machine in order to generate a periodic bias voltage on a conductor of the electrical machine, and a response signal thereto is evaluated. The injection frequency is adapted, i.e. adjusted or selected depending on a system quantity or system property of the electrical machine that is indicative of system noise interfering with, or superposing, the response signal. Hence, a static, predetermined choice of the injection frequency is abandoned in favour of a flexible approach respective of a most recent value of a system quantity of the electrical machine, which ultimately results in increased stability and reliability of the ground-fault protection system.

In a preferred variant of the invention, the line or grid frequency of an electrical power grid connected to the electrical machine is a first system quantity. The injection frequency is adapted according to a deviation of an actual line frequency from the nominal line frequency of 50 Hz or 60 Hz. In particular the injection frequency is repeatedly adjusted proportionally to the deviation of the actual line frequency from the nominal line frequency. Accordingly, the injection frequency scales with the noise spectrum, and any parasitic noise that may escape the nominal and static digital filters of the protection function has less potential to interfere with the response signal.

In a preferred variant of the invention, a noise spectrum *n(f)* reporting system noise superposing the response signal is a second system quantity. A frequency range including or covering a plurality of candidate injection frequencies is scanned for system noise, and a base injection frequency with lowest noise is selected from among the candidate frequencies. Hence, base system noise at the injection frequency is minimised.

In a preferred variant of the invention, a generator speed threshold *nₜ* separating two distinct noise regimes is a third system quantity. Two system noise spectra are measured or recorded during generator start-up as a function of generator speed, from zero to about nominal generator speed, representing system noise around a first and second candidate injection frequency. If a generator speed threshold can be identified below which a first noise spectrum is uncritical and above which the second noise spectrum is uncritical, the injection frequency during any future generator start-up is made to change from the first to the second candidate frequency at the threshold. Hence, earth fault protection can be provided right from generator speed zero.

According to an advantageous embodiment, injection frequency adaptation allows to choose different frequencies within the possible frequency bands for different electrical machines. Hence, interference present in existing protection schemes with static injection for generators connected solidly in parallel on the same busbar, i.e. devoid of any galvanic separation, is avoided. For dynamically adaptive injection frequencies communication between the relays provides every relay the current frequency setting of the other devices, so that a proper calibration without mutual disturbance can be done. A coordination scheme assures that not several relays start adapting at the same time leading to an unstable situation.

The invention may be beneficially applied to provide 100% Stator Earth Fault Protection in generators with a rated power as low as 20 MVA. In other words, generators with a rated power below 100 MVA that hitherto were limited to 95% Stator Earth Fault Protection for cost reasons may benefit from 100% Stator Earth Fault Protection without requiring any additional measures or investments for reliability reasons.

### BRIEF DESCRIPTION OF THE DRAWINGS

The subject matter of the invention will be explained in more detail in the following text with reference to preferred exemplary embodiments which are illustrated in the attached drawings, in which:
Fig.1 schematically shows a ground fault detection arrangement;
Fig.2 is a measured noise spectrum between of a 60 Hz generator; and
Fig.3 depicts two exemplary noise spectra recorded during a 50 Hz turbo-generator start-up, and an appropriately derived injection frequency *fᵢ*.

### DETAILED DESCRIPTION OF PREFERRED EMBODIMENTS

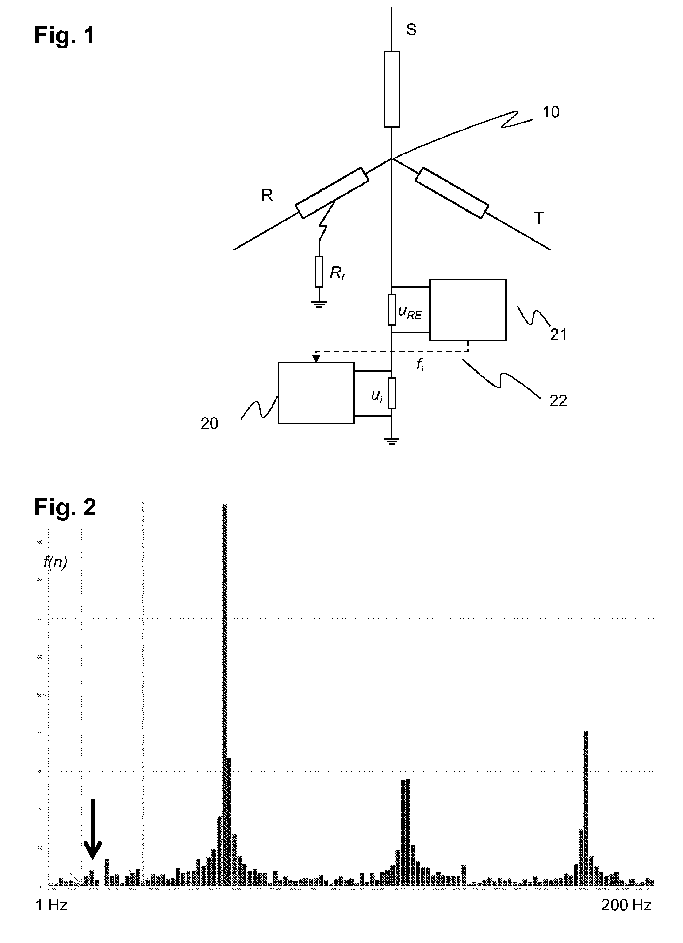

Fig.1 depicts a circuit arrangement for detecting ground faults on the stator windings (R, S, T) of an electrical machine, in particular a three-phase machine such as a generator. The star point of the winding, or generator neutral 10, is biased by means of an injection signal *uᵢ* generated in a signal generator 20 and fed to the star point via grounding resistances. In order to detect ground faults, a voltage *u_{RE}* across a grounding resistance is measured and fed to an evaluation unit in an earth fault protection relay 21. A fault resistance *R_{f}* is calculated in the evaluation unit based on the injected and measured voltages. An adapted injection frequency *fᵢ* is determined at the protection relay according to the options noted below, and communicated from the protection relay 21 to the signal generator 20 via communication link 22.

Fig.2 is a measured noise spectrum *n(f)* between 1 Hz and 200 Hz of a 60 Hz generator neutral. The noise spectrum is established by a configuration tool that measures all relevant frequencies entering an earth fault protection relay. To this end, a configuration tool is connected to a conductor of the generator at or near the same location as the protection relay. The protection relay may itself be adapted to execute these configuration tasks. At a rather late stage during commissioning and with potential noise sources in operation, the configuration tool scans the relevant frequencies and records the noise spectrum. In this context, noise is not only generated by the grid or the attached primary equipment such as a Start-up Frequency Converter SFC, but also caused by measurement transformers which distort a response signal.

In Fig.2, distinctive noise peaks are visible at 60, 120 and 180 Hz. At around the conventional injection frequency of 15 Hz (arrow), some parasitic noise is also visible. Accordingly, candidate injection frequencies around 12 Hz or 18 Hz are better suited. The configuration tool may determine, or suggest, one or several undisturbed frequency bands out of which a base, or nominal, injection frequency can be selected. With this, the commissioning engineer has a good guideline to select the optimal base injection frequency for the stator and rotor circuit, enabling the injection system to operate in an undisturbed frequency range with no or only little noise.

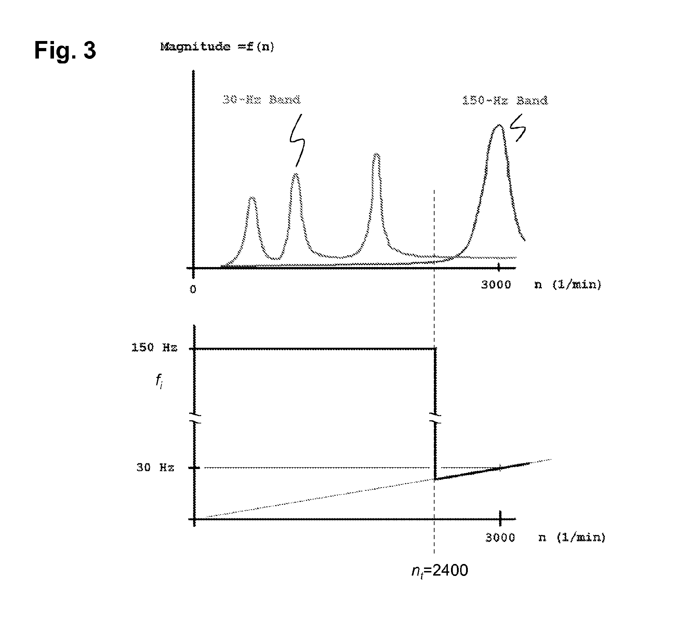

Fig.3, top graph, depicts an exemplary noise spectrum recorded during a 50 Hz turbo-generator start-up between 1 and 3300 rpm. In the 30 Hz band, harmonics develop at 600 rpm, 900 rpm and 1800 rpm; in the 150 Hz band, harmonics only show up at 3000 rpm, i.e. at or near the nominal grid frequency. Fig.3, bottom graph, depicts a stepwise injection frequency *fᵢ* adapted to the above noise spectra, and to which the digital filtering functions of the protection relay are made to correspond. In the beginning of the generator start-up process, the injection frequency is set to 150 Hz because no 150 Hz harmonics up to a threshold speed of 2400 rpm are expected, and afterwards, i.e. at a generator speed in excess of 2400 rpm, the injection frequency is reduced to e.g. a base injection frequency of about 30 Hz, because the 30 Hz harmonics will have been gone at this level of speed.

In order to determine the appropriate threshold or switchover generator speed, a frequency selective noise spectrum as in Fig.3 has to be recorded at least during the very first start-up process. Subsequently, such spectrum may be updated repeatedly. Again, this may be performed by a dedicated configuration tool or by the protection relay itself At least for all subsequent start-up processes, a working ground fault protection may then be established right from generator speed zero.

In order to mitigate filter errors in e.g. under-frequency conditions, grid frequency tracking is enabled, and an actual injection frequency *fᵢ* is made to deviate from the base injection frequency previously chosen. This is depicted in Fig.3, bottom graph, by the finite slope after the discontinuous drop from the initial 150 Hz injection frequency. Contrary to the static base injection frequency of 30 Hz, the actual injection frequency *fᵢ* is varying proportional to the grid frequency or generator speed, and is only equal to the base injection frequency in case of 50 Hz sharp. By way of example, a grid frequency of 48.5 Hz will lead to a deviation in the injection frequency of 0.9 Hz. Based on the assumption that the entire noise spectrum of the type depicted in Fig.2 (including the white spots) scales with the grid frequency, parasitic noise that the static digital filters at the protection relay (which filters target strict multiples of the nominal grid frequency) are unable to block is thus circumvented. In order to arrange for the corresponding minor adaptations around the base injection frequency, the actual grid frequency is preferably being determined by the protection relay itself.

In parallel or alternatively to the abovementioned base injection frequency adaptation by evaluating a noise profile, adaptations of the base injection frequency in relation to different generator load conditions is also possible. Such load conditions reflect different stages before and after generator load pickup; such as generator load above or below 50% of nominal load; or generator breaker closed or open. Base injection frequencies will be determined and stored in look-up tables for each identifiable load condition.

### LIST OF REFERENCE NUMERALS

- 10: generator neutral
- 20: signal generator
- 21: fault protection relay
- 22: communication link

## Claims

1. A method of adapting a ground-fault protection system for an electrical machine, wherein the system injects an injection signal *uᵢ* with an injection frequency *fᵢ* into a conductor of the electrical machine and evaluates a response signal *u_{RE}* thereto in order to identify a ground-fault in the electrical machine, comprising
- measuring a system quantity of the electrical machine indicative of system noise, and
- adapting the injection frequency according to the system quantity.

2. The method according to claim 1, wherein the system quantity is the line frequency *f_{g}* of an electrical power grid connected to the electrical machine, comprising
- adapting the injection frequency *fᵢ* according to a deviation of the line frequency from a nominal line frequency.

3. The method according to claim 2, wherein the system quantity is a noise spectrum *n(f),* comprising
- measuring the noise spectrum over a frequency range including a plurality of candidate injection frequencies, and
- selecting a base injection frequency with lowest noise from among the candidate injection frequencies.

4. The method according to claim 3, wherein the system quantity is a generator speed threshold *nₜ*, comprising
- measuring, during generator start-up, a first system noise spectrum for a candidate start-up injection frequency and a second system noise spectrum for a candidate base injection frequency,
- identifying a generator speed threshold below which the first noise spectrum is acceptable and above which the second noise spectrum is acceptable, and
- selecting the injection frequency to be the start-up injection frequency below the threshold and the base injection frequency above the generator speed threshold.

5. The method according to claim 3, wherein a further electrical machine is conductively connected to the first electrical machine, comprising
- selecting a further base injection frequency for the further machine that is different from the base injection frequency chosen for the electrical machine.

6. The method according to any one of claims 1 to 5, wherein the ground fault protection system is used for rotor and/or stator ground fault protection in a generator with a power in excess of 20 MVA.

7. A ground-fault protection system for an electrical machine, comprising a signal generator (20) for injecting a frequency signal *uᵢ* with an injection frequency *fᵢ* into a conductor (10) of the electrical machine, and an earth fault protection relay (21) that evaluates a response signal *u_{RE}* thereto in order to identify a ground-fault in the electrical machine,
**characterized in that** the signal generator (20) is communicatively connected to the protection relay (21) via a communication link (22) to receive a value of the injection frequency *fᵢ* adapted according to a method as claimed in any one of claims 1 to 5.
